# EUROPEAN PATENT SPECIFICATION

(11) **EP 2 440 622 B1**
(45) Date of publication and mention of the grant of the patent: **31.08.2016**
(21) Application number: 10726389.9
(22) Date of filing: 11.06.2010
(51) Int. Cl.: C09D 5/00

(54) **METHOD FOR PROTECTING A SUBSTRATE FROM LIGHTNING STRIKES**
VERFAHREN FÜR DEN BLITZSCHUTZ EINES SUBSTRATS
PROCÉDÉ DE PROTECTION D'UN SUBSTRAT CONTRE LES IMPACTS DE FOUDRE

(30) Priority: 12.06.2009 US 186415 P; 12.06.2009 US 186492 P
(43) Date of publication of application: 18.04.2012
(73) Proprietor: LORD Corporation, Cary, NC 27511 (US)
(72) Inventor: CARRUTHERS, Seth, B., Raleigh NC 27612 (US); HUFFMAN, Nicolas, D., Raleigh NC 27605 (US)
(74) Representative: dompatent von Kreisler Selting Werner - Partnerschaft von Patent- und Rechtsanwälten mbB
(86) International application number: PCT/US2010/038250
(87) International publication number: WO 2010/144762

(56) References cited:
- WO-A2-2007/127032
- US-A1- 2009 104 437

## Description

### FIELD OF THE INVENTION

The present invention relates to a method of protecting a substrate from lightning strikes.

### BACKGROUND OF THE INVENTION

Owing to excellent combinations of strength and weight, composite materials are being increasing used to replace aluminum in aircraft structures. Although this affords significantly increased fuel efficiency and/or greater payload capacity, aircraft structures unfortunately become more vulnerable to lightning damage. This increased vulnerability is rooted in the inferior electrical conductivity of composites, such as those based on carbon fiber reinforced materials, relative to that of aluminum metal. Naturally, the less conductive a material is the more energy that it will absorb owing resistive heating mechanisms. It has been reported that carbon fiber composites can absorb nearly 2,000 times the amount of energy from lightning strikes as compared to the same mass of aluminum. The increased absorbed energy leads to increased "direct" and "indirect" effects.

Direct effects are associated with physical or "direct" damage to load bearing structures, with the worst types of damage being severe punctures through composites laminates. "Indirect" effects are associated with electrical surges caused by the lightning's massive electromagnetic field. These surges can disrupt avionics and in turn compromise the pilot's ability to control the aircraft. Indirect effects are even more of concern lately as aircraft controls are increasingly moving towards fly-by-wire systems. It is for this reason why massive amounts of electromagnetic interference (EMI) shielding materials in the form of boxes, gaskets, metal foils and meshes, adhesives, metal sheathing, etc. are used to shield electrical components, wiring, and connections.

In order to protect composites against the aforementioned effects, aircraft designers seek to keep the strong electrical currents on the outer surface aircraft by integrating highly, conductive skins in the composite structure. Numerous attempts to produce such lightning strike protection (LSP) skins have been made and/or proposed, each with varying degrees of success. For example, metal wire meshes and expanded metal foils (EMF) based on metals such as copper, aluminum, or bronze have been embedded in a surfacing (or adhesive) films and co-cured with underlying composite prepregs. Alternatively, individual wires have been interwoven with carbon fibers to produce hybrid prepregs. Similarly, metal deposition techniques have been employed to coat carbon-fibers or other reinforcing fibers in their raw or woven forms. In addition to metalized fibers, flame spray is another LSP approached used, which involves depositing molten metal, typical aluminum onto substrates.

More recent attempts had been made to overcome the lack of z-conductivity in the fiber prepregs as well as the aforementioned meshs, EMFs, hybrids, and metalized fibers; this has involved incorporating high aspect ratio conductive fillers like carbon nanotubes (or nanofibers), graphene, or nanostrands into resins that are used as a standalone adhesive film or in conjunction with carbon fiber or carbon fiber prepreg. Similarly, low aspect ratio particles or combinations thereof with high aspect ratio particles have been used for the same purpose. These approaches, although much more efficient at increasing conductivity relative to heavily filled resins, they still lack the ultimate conductivity and current carrying capacity needed in LSP applications. Other approaches have tried to alleviate this issue by replacing non-conductive resins with intrinsically conducting polymers. Unfortunately, these and the above-mentioned materials still suffer from limited strike protection, substantial weight gain, manufacturing challenges, and/or limitations in basic properties such as thermal and electrical conductivity, current carrying capacity, viscosity (or handling), and/or mechanical properties.

US 2009/0104437 A1 discloses a method for synthesizing silver nano-particle colloids in a container and stabilizing said colloid by combining it with a stabilizing solution.

WO 2007/127037 A2 concerns a one-part ultraviolet light and abrasion resistant pigmented surfacing film composition adapted for co-curing with an amine cured composite prepreg material

Of the different systems mentioned in the literature, those based on metal foils, particularly EMFs, have been most successful in being reduced to practice. Despite their presence in a majority of fixed and rotary wing aircraft, EMFs possess a number of undesirable features. For example, EMF systems exhibit limited "indirect protection" by providing shielding over a limited range of frequencies. EMF systems have been shown to very susceptible to frequencies at and above about the 1 GHz range. Because of this, aircraft designers often add extra or more robust shielding materials to the aircraft to safeguard against disruptions in electrical communications which in turn adds considerable weight.

EMF systems also suffer from handling issues during manufacturing and repairs. Specifically, EMFs must be integrated with adhesives films at the supplier or the original equipment manufacturer (OEM) which can be challenging and costly. Furthermore, EMFs are difficult to conform to contoured tooling, suffer tack issues, and are easily wrinkled and damaged during normal handling and cutting operations. There are also issues in maintaining electrically integrity between panels during joining, splicing, and grounding operations. It for such reasons, OEMs are forced to lay up these materials by hand, thereby leading to consider labor time and cost. Numerous attempts have been made to automate layup of EMF with little success owing to these same issue in addition weight penalties due the overlapping EMF at many splices. In addition to handling, metal meshes based on aluminum and copper are prone to corrosion owing to differences in galvanic potentials between the metal and the underlying carbon. To combat this issue, isolation plies are often added between the EMF layer and the carbon plies. Unfortunately, adding plies adds extra steps, increases labor, costs, and adds more weight to the aircraft.

Repair is also an issue with EMF systems. Damaged foils must be adequately removed through sanding and cutting or scarfing operations and patched with a new EMF material. Splicing of the new foil to the existing foil such that the conductive pathways align is again a challenge as well as dealing with porosity effects arising from air entrapment.

Given the above, there is need for improved LSP materials that are: highly conductivity in the z-direction, lighter in weight, corrosion resistant, less complex (i.e. fewer layers), and easy to apply and integrate during assembly and repair of composite structures, and correspondingly capable of being automated in a manufacturing operation.

### SUMMARY OF THE INVENTION

The present invention concerns a method for shielding a substrate from lightning strikes, said method comprising:
(i) providing a substrate,
(ii) providing lightning strike protectant composition to the substrate, wherein the lightning strike protectant composition comprises a filled, curable material capable of self-assembling to form conductive pathways during a cure process, wherein the curable material comprises a curable organic compound and a filler, said organic compound comprising a relatively non-polar resin and a polar curing agent and said filler being comprised of particles, said particles being coated with a non-polar coating and comprising a material that is electrically conductive, and said coated filler particles being mixed in said organic compound, and
(iii) curing the composition by means of the application of heat, wherein curing agent reacts with the resin of the curable organic compound forming a polymer having polar moieties thereon, resulting in a repulsive interaction between the non-polar coating on the filler and the polar moieties on the polymer, causing the filler to self-assemble into conductive pathways through the composition.

In a preferred embodiment of the present invention, the materials described in U.S. Patent Application No. 12/055,789, filed March 26, 2008, and published as U.S. 2010/0001237, are employed as a conductive matrix formed in-situ during the cure and applied to a substrate to provide direct and indirect protection against lighting strikes.

In an effort to address the various issues with existing LSP systems, an embodiment of the present invention employs a lightning strike protectant composition comprising a reactive organic compound and electrically conductive filler that during the cure of the organic compound is capable of self-assembling into a heterogeneous structure comprised of a continuous, three-dimensional network of metal situated among (continuous or semi-continuous) polymer rich domains whose electrical conductivity is within several orders of magnitude of that of bulk metals.

In another embodiment of the present invention, a method for protecting a substrate from lightning strikes is provided comprising providing a substrate, providing a lightning strike protectant composition to the substrate, wherein the lighting strike protectant comprises a filled, curable material capable of self-assembling to form conductive pathways during a cure process. In another embodiment of the present invention, the curable material comprises a curable organic compound and a filler, preferably a coated silver filler, and the filler and the organic compound exhibit an interaction during the cure of the organic compound, said interaction causing the filler to self-assemble into conductive pathways.

In yet another embodiment of the present invention, the composition is cured thereby forming conductive pathways therethrough, and the conductivity of the cured self-assembled composition is greater than 100 times the conductivity of a cured non-self-assembled composition having an equivalent amount of the conductive filler.

In further embodiments of the present invention, the curable organic compound comprises diglycidyl ether of bisphenol F, and the curable organic compound further comprises a cure agent, preferably comprising a polyamine anhydride adduct based on reaction between phthalic anhydride and diethylenetriamine.

In an additional embodiment of the present invention, the lightning strike protectant composition further provides shielding of electromagnetic radiation having a frequency of between 1 MHz and 20GHz, wherein said shielding reduces the electromagnetic radiation by at least 20 decibels.

In another aspect of the present invention, the step of providing a lightning strike protectant composition to a substrate comprises the following steps, identifying a damaged section of a lightning strike protection system comprising at least one discontinuous conductive pathway, depositing the composition onto the damaged section, and curing the deposited composition to provide at least one self-assembled conductive pathway completing the at least one discontinuous conductive pathway in the damaged section.

In further embodiments of the present invention, the damaged lightening strike protection system comprises at least one of a conductive expanded metal foil, metal mesh, carbon-metal fiber co-weaves, metalized carbon, or filled conductive polymer, and in another embodiment the damaged lightening strike protection system comprises a curable material capable of self-assembling to form conductive pathways during a cure process.

In an additional aspect of the present invention, a method for non-destructive testing of a lightning strike protectant (LSP) composite is provided comprising, providing an electrically conductive composition capable of providing lightning strike protection, measuring an electrical property of the composition, and equating the measured electrical property of the composition with the electrical conductivity of a previously degraded sample of the composition to determine the degree of degradation of the composite. In one embodiment of the present invention, the composition comprises a curable material capable of self-assembling to form conductive pathways during a cure process. And in another embodiment of the present invention, the electrical property comprises electrical resistivity.

Because of the heterogeneous structure formed, the LSP composition is able to induce a percolated network of conductive particles at particle concentrations considerable below that of traditional compositions that possess homogenous structures comprised of particles uniformly situated throughout the polymer matrix. Moreover, the heterogeneous structure formed during curing permits the sintering of particles thereby eliminating contact resistance between particles and in turn leading to dramatic improvements in thermal and electrical conductivity. Moreover, the continuous pathway of sintered metal permits carrying of substantial amounts of heat and electrical current encountered during a lightning strike event. The combination of lower filler loading and the related self-assembling of continuous pathways permits LSP materials that are lighter weight and easier to manufacture and repair which are desirable for fuel savings, payload capacity reasons, and construction and repair reasons.

Due to its isotropic nature, the composition is conductive in all orthogonal directions; thereby leading to significantly improved electrical and thermal conductivity in the z-direction of composite structures. In turn, this improvement allows for considerable reduction in capacitive effects and heat buildup associated with non-conductive resins layers present in composite laminate as well as existing EMF LSP systems and the like.

In another embodiment of the present invention, because of the organic component's ability to react and form covalent bonds, it can be easily co-cured with or cured on reactive or non-reactive (e.g. thermoplastic or a previously reacted thermoset) substrates, respectively. In addition, proper selection of resin chemistry potentially affords the replacement of one or more layers typically found on the outer part of aircraft, such as primer and topcoat layers used to paint the aircraft. Furthermore, with appropriate selection of filler, is capable of providing lighting strike and corrosion performance without the need of an isolation ply.

Furthermore, because of its highly conductive, isotropic nature it is capable of being used as a multifunctional material for the purpose of protection against lighting strikes and, but not limited to, shielding against electromagnetic fields, eliminating buildup of static charge, and a heat conduit for melting ice (e.g. deicing material). Moreover, the multifunctional ability of the composition overcomes the issues of having to combine metallic structures, e.g. EMFs, with adhesive films prior to its integration into the composite structure.

Furthermore, the uncured (A-staged or B-staged, but not C-staged) composition has desirable handling properties and is easily adaptable to various application forms. Such forms include, but are not limited to, a dispensible adhesive, a spray coating, an adhesive film, or as resin to be used in or in conjunction with a composite fiber prepreg or tape.

In a further embodiment of the present invention, the self-assembling composition may be used to produce a laminate structure of two or more layers such that the top layer comprises the conductive self-assembling composition and the underlying layers comprise lighter weight, electrically conductive or non-conductive resin layers. Furthermore, the laminate structure affords increase surface conductivity while maintaining a given weight relative to a monolithic film of lower surface conductivity. Furthermore, the thickness of each layer can be varied to further increase surface conductivity while maintaining a give weight.

Furthermore, in an embodiment of the present invention, the uncured composition is employed in combination with an existing LSP system to create a unique hybrid structure thereby producing attractive combinations of LSP protection and weight. Examples include, but are not restricted to, the self-assembling material used as a B-staged film for embedding solid metal foils, EMFs, metalized fibers, metalized woven fibers, metalized non-wovens (e.g. veils), or metal-carbon fiber co-weaves.

In a further embodiment of the present invention, the self-assembled composition further provides secondary protection to a substrate. For example, though an initial lightning strike may create physical damage in the immediate area of the strike, electrical current may surge throughout the substrate/structure and damage distant electrical components or surfaces. The self-assembled conductive material of the present invention provides a means for dissipating and controlling this electrical surge in addition to providing primary protection to the immediate area of the strike.

In another embodiment of the present invention, the self-assembling composition is capable of electrically bridging interfaces associated with the assembly of different sections of LSP materials or during the repair of LSP materials. In additional embodiments of the present invention, the material is applied as an uncured spray coating, uncured (not C-staged) film adhesive, or as flexible cured film that is bonded using a secondary adhesive or resin that is optionally filled with a conductive filler. In a further embodiment of the present invention, the existing or adjoining substrate to be repaired or bonded may be of the same composition as the self-assembling heterogeneous material or be based on existing LSP systems such as those based on, but not limited to, EMFs.

Furthermore, the self-assembling nature of the composition makes it possible to use automated equipment for applying LSP to composite structures. Examples include, but are not restricted to, applying the self-assembling material in spray form using automated spray equipment such that the sprayed material is applied to uncured fiber reinforced polymer skin on a male mold structure, or to the surface of a female mold structure which has been pretreated with a release agent. Furthermore, the self-assembling material could be applied in combination with multiple unidirectional filaments (e.g. fiber or tape) using automated fiber or tape placement machines. The ability to form continuous electrically conductive pathways following the curing of adjacent filaments overcomes the aforementioned issues associated with state of art materials.

Furthermore, because of its highly conductive, isotropic nature, the materials discussed herein lend themselves to quantitative non-destructive testing. In a further embodiment of the present invention, the conductivity of the cured composition may be measured for the purposes of, but not limited to, assessing the defects during the manufacturing of the protected part, assessing the extent of damage of the LSP material, or degradation of the material of materials performance in the field.

It is also to be understood that the phraseology and terminology herein are for the purposes of description and should not be regarded as limiting in any respect. Those skilled in the art will appreciate the concepts upon which this disclosure is based and that it may readily be utilized as the basis for designating other structures, methods and systems for carrying out the several purposes of this development.

So that the manner in which the above-recited features, advantages and objects of the invention, as well as others which will become more apparent, are obtained and can be understood in detail, a more particular description of the invention briefly summarized above may be had by reference to the embodiment thereof which is illustrated in the appended drawings, which drawings form a part of the specification and wherein like characters of reference designate like parts throughout the several views. It is to be noted, however, that the appended drawings illustrate only preferred and alternative embodiments of the invention and are, therefore, not to be considered limiting of its scope, as the invention may admit to additional equally effective embodiments.

### BRIEF DESCRIPTION OF THE DRAWINGS

FIGURE 1 is a view of a composite laminate in an embodiment of the present invention.
FIGURE 2 is a graph of electromagnetic shielding effectiveness verses frequency for a self-assembled material employed in an embodiment of the present invention.
FIGURE 3 is a graph of damage to an LSP composite in an embodiment of the present invention after a Zone 1A strike versus the surface electrical resistance of the coating.

### DETAILED DESCRIPTION OF THE INVENTION

In a first embodiment of the present invention a method for protecting a substrate from lightning strikes is provided comprising providing a substrate, and providing a lightning strike protectant composition to the substrate, wherein the lightning strike protectant composition comprises a filled, curable material capable of self-assembling to form conductive pathways during a cure process. The conductive filler self-assembles into conductive pathways during cure of the polymer matrix to provide a conductive LSP material which addresses many of the disadvantages of the materials of the prior art.

The mechanism of self-assembly and structure formation is achieved through the proper selection of component materials and adherence to particular processing conditions. In one embodiment of the present invention, the filler component comprises a conductive filler (electrical and optionally, thermal) and the organic compound comprises a monomer and optionally a curative agent. The formation of filler rich domains during reaction of the organic material allows for direct filler-to-filler particle contacts to be made. In the presence of heat the particles may further sinter together. Sintering eliminates the contact resistance between the previously non-sintered filler particles thereby substantially improving the thermal and/or electrically conductivity of the composite.

While not fully understood and not wishing to be bound by this theory, it is believed that the self-assembly and domain formation and sintering are sensitive to the organic materials cure temperature, the cure time, and the level of pressure applied during the cure. In other words, domain formation and sintering are kinetically driven processes. In a still a further embodiment, the rate at which the sample is heated will affect the extent of domain formation and sintering. In total, the processing conditions can be tailored to achieve a conductive adhesive having the best combination of properties at minimal filler loading, which often translates to lower cost and opportunity to take advantage other properties that are adversely affected by high filler loadings. In some cases, when the adhesive is employed in an application that is not able to withstand high sintering temperatures, higher pressures or non-traditional sintering techniques may used to achieve exceptionally high conductivities.

The filler component and reactive organic compounds are chosen so as to create a homogeneous mixture when mixed. However, during the cure, it is believed that the resulting polymer formed from the organic compound then has a repulsive interaction with the filler so as to allow the composition to self-assemble into a heterogeneous compound having filler-rich domains wherein the filler composition is significantly higher than the bulk filler concentration. Thus, while the overall (bulk) filler concentration of the compound does not change, the filler particles and the organic component self-assemble *in situ* into respective regions of high concentration. This phenomenon can lead to a self-assembled network of interconnected filler particles formed *in situ* from a mixture having very few, if any, initial filler-filler contacts.

There are several approaches which may be employed to create the repulsive interaction between the filler component and the organic compound. However, in the present invention, this is achieved by coating a filler particle with a non-polar coating and mixing the coated filler in a reactive organic compound comprising a relatively non-polar resin and a polar curing agent. In an uncured state, the resin, curative, and filler form a relatively homogeneous mixture in which the coated filler and the resin are compatible with one another and form a relatively homogeneous mixture. However, with the application of heat the curing agent reacts with the resin forming a polymer having polar moieties thereon, resulting in a repulsive interaction between the non-polar coating on the filler and the polar moieties on the polymer. This repulsive interaction leads to the self-assembling of polymer-rich and filler-rich domains whose respective concentrations are significantly higher than the bulk concentrations of polymer and filler, respectively. Moreover, extensive domain formation is capable of creating continuous filler-rich domains with substantial particle to particle contact between most of the filler particles.

Other types of interactions capable of creating repulsive effects upon curing of the organic compound in the presence of the filler, could consist of, but are not limited to, electrostatic interactions, hydrogen bonding interactions, dipole-dipole interactions, induced dipole interaction, hydrophobic-hydrophilic interactions, van der Waals interactions, and metallic interactions (as with an organometalic compound and metallic filler). Other forms of repulsive interactions could arise from entropic related effects such as molecular weight differences in the polymers formed from the organic compound(s). Additionally, repulsive interactions could arise as a result of an external stimulus such as electrical field.

The domains formed upon curing of the organic compound in the presence of the filler results in filler-rich domains having a higher than bulk (average) filler concentrations and in organic rich domains having lower than bulk (average) filler concentrations. The areas of higher than average filler concentration can form semi-continuous or continuous pathways of conductive filler material extending throughout the body of the cured composition. These pathways provide a low resistance route through which electrons and/or thermal phonons can travel. In other words, the pathways or channels allow for greatly enhanced thermal or electrical conductivity. This conductive pathway may be further enhanced by sintering the filler particles together. Such highly conductive pathways are particularly beneficial for LSP given the large amount of electrical current and heat that must be dissipated during a strike event.

Sintering, as it is understood in the art, is a surface melting phenomenon in which particles are fused together at temperatures below the materials bulk melting temperature. This behavior is brought about by a tendency of the material to relax into a lower energy state. As such, selection of filler type, size, and shape can greatly affect the sinterability of the filler particles. Certain particles, such as thin, wide, flat, plates are often formed by shearing large particles via various milling processes. This process imparts a large amount of internal stress in addition to creating a large amount of surface area. When a certain amount of heat is added to the particles, they will have the tendency melt and fuse together thereby relieving the internal strain and decreasing the overall surface energy of the particles. For this reason, the preferred filler particles for use in the present invention are those that comprise some degree of electrical and, optionally, thermal conductivity and sinter easily. In a still further embodiment of the present invention, the preferred filler comprises a metallic particle that has been subjected to cold working which has imparted strain into the structure of the filler which further enables sintering.

The sintering temperature will vary according to the material chosen as the filler, as well as the geometry of the filler particle. However, in a preferred embodiment of the present invention, it is advantageous to balance the cure of the organic compound and the sintering of the filler such that they occur simultaneously. In this embodiment, the cure temperature and profile is selected to coincide with the sintering temperature of the filler, so as the organic compound becomes repulsive to the filler and the filler particles are forced together, the individual filler particles can sinter once particle to particle contact is made. This is believed to be responsible for the continuous filler structure seen throughout the fully cured composition. In a preferred embodiment of the present invention, the sintering temperature is at least 100 °C, more preferably 150 °C, and even more preferably above 150 °C for a silver flake filler.

In another embodiment of the present invention, a low-temperature cure may be desirable. For example when coating/applying the curable composition to a heat sensitive substrate, the cure agent and cure mechanism may be tailored to achieve a cured, self-assembled material at temperatures below 50 °C. In embodiments of the present invention where sintering does not take place during a cure step, for example in a low-temperature cure environment, the particles may initially form self-assembled pathways that are not sintered. A sintering step may then be later added. This later-added sintering step may comprise heating of the self-assembled material, either through ambient heating, or electrically induced heating such as through a lightning strike. In embodiments not according to the present invention, the self-assembling composition may be cured without the addition of heat. However, in the present invention, the composition is cured via application of heat to the composition. Heat curing is commonly accomplished in a cure oven such as a convection oven or an autoclave, whereby hot air or radiated heat is used to increase the temperature of the composition. In alternate embodiments not according to the present invention, other methods of cure may be employed such as induction curing in an electromagnetic field, microwave curing, infrared curing, electron beam curing, ultraviolet curing, and curing by visible light. Additionally, the cure reaction may be self accelerated through the use of an exothermic cure reaction. A non-thermal cure may be desirable, for example, when the composition is coated on a temperature sensitive substrate such as a plastic.

In one embodiment of the present invention the filler comprises inorganic fillers. Available fillers include pure metals such as aluminum, iron, cobalt, nickel, copper, zinc, palladium, silver, cadmium, indium, tin, antimony, platinum, gold, titanium, lead, and tungsten, metal oxides and ceramics such as aluminum oxide, aluminum nitride, silicon nitride, boron nitride, silicon carbide, zinc oxide. Carbon containing fillers could consist of graphite, carbon black, carbon nanotubes, and carbon fibers. Suitable fillers additionally comprise alloys and combinations of the aforementioned fillers. Additional fillers include inorganic oxide powders such as fused silica powder, alumina and titanium oxides, and nitrates of aluminum, titanium, silicon, and tungsten. The particulate materials include versions having particle dimensions in the range of a few nanometers to tens of microns.

In an embodiment of the present invention, the filler is present at 40 volume percent or less, based on the total volume of the cured composition. In a more preferred embodiment of the present invention, the filler is present at 30 volume percent or less, based on the total volume of the cured composition. In a most preferred embodiment of the present invention, the filler is present at 15 volume percent or less, based on the total volume of the cured composition.

In the present invention, the filler comprises a material that is electrically and, optionally, thermally conductive. Although metals and metal alloys are preferred for use in several embodiments of the present invention, the filler may comprise a conductive sinterable non-metallic material. In an alternate embodiment of the present invention the filler may comprise a hybrid particle wherein one type of filler, for example a non-conductive filler, is coated with a conductive, sinterable material, such as silver. In this manner, the overall amount of silver used may be reduced while maintaining the sinterability of the filler particles and conductivity of the sintered material.

In an embodiment of the present invention, the filler component must be able to interact with the organic compound to impart a heterogeneous structure in the finished material. In the present invention as discussed above, this is accomplished through the interaction of a polar organic compound with a non-polar filler. For preferred filler materials, such as metals, the filler is coated with a material comprising the desired degree of polarity. In one preferred embodiment of the present invention, the filler coating comprises a non-polar fatty acid coating, such as stearic, oleic, linoleic, and palmitic acids. In a still further embodiment of the present invention, the filler coating comprises at least one of several non-polar materials, such as an alkane, paraffin, saturated or unsaturated fatty acid, alkene, fatty esters, waxy coatings, or oligomers and copolymers. In additional embodiments of the present invention, non-polar coatings comprise ogranotitanates with hydrophobic tails or silicon based coatings such as silanes containing hydrophobic tails or functional silicones.

In a further embodiment of the present invention, the coating (or surfactant, coupling agent, surface modifier, etc.) is applied to the filler particle prior to the particles' incorporation into the curable composition. Examples of coating methods are, but not limited to, are deposition of the coating from an aqueous alcohol, deposition from an aqueous solution, bulk deposition onto raw filler (e.g. using a spray solution and cone mixer, mixing the coating and filler in a mill or Attritor), and vapor deposition. In yet a further embodiment, the coating is added to the composition as to treat the filler prior to the reaction between the organic components (namely the resin and curative). In an alternate embodiment not in accordance with the present invention, the polarity of the filler/coating and polymer are reversed wherein the filler/coating comprises a polar moiety and the organic compound comprises a non-polar polymer. Similarly, in an embodiment not in accordance with the present invention, in which a repulsive effect other than polarity is employed to drive the self-assembly, the active properties of the filler and organic components may be interchanged.

In a preferred embodiment of the present invention the organic compound comprises an epoxy resin and a cure agent. In this embodiment, the organic compound comprises from 60 to 100 volume percent of the total composition. In this embodiment, the organic compound comprises from 70 to 85 percent by weight of a diglycidal ether of a bisphenol compound, such as bisphenol F, and 15 to 30 percent by weight of a cure agent, such as a polyamine anhydride adduct based on reaction between phthalic anhydride and diethylenetriamine.

In additional embodiments of the present invention, suitable organic compounds comprise monomers, reactive oligomers, or reactive polymers of the following type siloxanes, phenolics, novolac, acrylates (or acrylics), urethanes, ureas, imides, vinyl esters, polyesters, maleimide resins, cyanate esters, polyimides, polyureas, cyanoacrylates, benzoxazines, unsaturated diene polymers, and combinations thereof. The cure chemistry would be dependent on the polymer or resin utilized in the organic compound. For example, a siloxane matrix can comprise an addition reaction curable matrix, a condensation reaction curable matrix, a peroxide reaction curable matrix, or a combination thereof. Selection of the cure agent is dependent upon the selection of filler component and processing conditions as outlined herein to provide the desired self-assembly of filler particles into conductive pathways.

In another embodiment, due to its isotropic nature, the composition is conductive in all orthogonal directions; thereby lending to significantly improved electrical and thermal conductivity in the z-direction of composite structures. In turn, this improvement allows for considerable reduction in capacitive effects and heat buildup associated with non-conductive resins layers present in composite laminate as well as existing EMF LSP systems and the like. Furthermore, the material can facilitate heat and electron transfer by bridging adjacent carbon fibers within or between the layers of the composite substrate. In yet a further embodiment of the present invention, the self-assembled material's highly conductive, isotropic nature, lend themselves to quantitative non-destructive testing as discussed in greater detail below.

Furthermore, the uncured (A-staged or B-staged, but not C-staged) self-assembling composition has desirable handling properties and is easily adaptable to various application forms. In one embodiment of the present invention, the self-assembling composition comprises a flowable adhesive (e.g. liquid or paste) that is capable of bonding to a reactive or non-reactive substrate during the cure of organic compound. Thus, the self-assembled composition comprises adhesive qualities which enhances certain application techniques and allows for stronger mechanical connections to substrates which in turn enhances the electrical connections between the substrate and the conductive network within the adhesive. The result is an adhesive capable of bonding two adjacent surfaces together while additionally providing LSP protection.

In a further embodiment of the present invention, the self-assembling composition is provided as a two-part system wherein the curable organic component is present in an "A-side" and the cure agent is present in a "B-side", such that when mixed, the cure reaction is begun. The filler and any other optional components may reside in either the A-side, B-side or both.

In another embodiment the composition is the form of a B-staged film adhesive that is commonly used in composite applications. Furthermore, the film adhesive has optional carrier fabric, such as a non-woven veil to enhance handling properties. In yet another embodiment, the veil may be electrically conductive to further enhance the LSP ability of the composition.

In another embodiment of the present invention, the composition can be applied as a spray to a substrate by addition of a solvent to the composition. In a preferred embodiment of the present invention, the solvent comprises a structure suitable for dissolving (in full or in part) the organic compound while capable of being evaporated under common processing conditions for composite structures. In a preferred embodiment of the present invention, wherein an epoxy resin is employed, the solvent comprises, but is not limited to, acetone, methylethylketone, toluene, xylene, benzyl alcohol, butyl acetate, cyclohexanone, dimethoxyethane, trichloroethylene, glycol ethers, and mixtures thereof. Moreover, the choice of solvent will be also dictated by the curative used. In one preferred embodiment, it is desirable to select a chemical such as acetone that acts a solvent for the epoxy resin and a non-solvent for the polyamine anhydride adduct. In one preferred embodiment of the present invention, the solvent comprises 0.25 to 1.5 parts by weight of the non-solvent components.

In another embodiment of the present invention, the composition is used in conjunction with fiber reinforcement (e.g. fibers, fiber tows, woven fibers or fabrics and the like) to produce a coated or pultruded fibers, composite prepreg, tapes, and the like. In other words, the composition acts as the traditional resin component used to form traditional prepreg and related materials. In a further embodiment, the self-assembled material discussed herein is amenable and facilitates many known manufacturing techniques including infiltration techniques, such as resin transfer molding, resin film infusion, vacuum assisted resin transfer molding etc.

In a further embodiment of the present invention, the self-assembling composition may be used to produce a laminate structure of two or more layers such that the top layer comprises the conductive self-assembling composition and the underlying layer(s) is comprised of lighter weight, electrically conductive resin, and/ or a non-conductive resin such a traditional surfacing film. Furthermore, the non-conductive resin may be said, the laminate structure affords increase surface conductivity while maintaining a given weight relative to a monolithic film of lower surface conductivity. Furthermore, the thickness of each layer can be varied to further increase surface conductivity while maintaining a give weight.

In yet another embodiment of the present invention, the uncured composition is employed in combination with an existing LSP system to create a unique hybrid structure thereby producing attractive combinations of LSP protection and weight. Examples include, but are not restricted to, the self-assembling material used a B-staged film for embedding solid metal foils, EMFs, metalized fibers, metalized woven fibers, metalized non-wovens (e.g. veils), or metal-carbon fiber co-weaves.

The methods and materials of the embodiments of the present invention may be used to provide lightning strike protection to a variety of substrates, parts, machines, vehicles, and apparatus. In a preferred embodiment of the present invention, the methods and materials of the present invention are employed to provide LSP to vehicles, including aircraft, sea, and ground vehicles, as well as structures such as antennas, radars, and wind turbines.

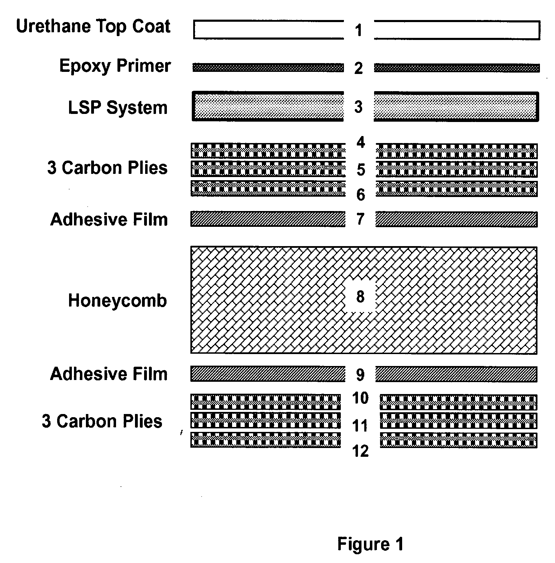

Referring to Figure 1 an example of substrate in an embodiment of the present invention is provided as is commonly encountered in commercial composite applications such those involved in the aerospace industry. The substrate in Figure 1 is compromised of sandwich-type laminate structure in which multiple layers of structural carbon fiber prepreg 4-6 and 10-12 sandwich an inner, lightweight honeycomb core 8 with layers of adhesive film 7 and 9 adhering the assembly together. The LSP system 3 is applied on top of the upper carbon plies 4-6. It should be noted that commercial LSP systems often possess a glass fiber isolation ply which is sometimes used to prevent galvanic corrosion that occurs between carbon fiber substrate and the metallics in the LSP system (especially those that possess a dissimilar galvanic potential relative to that of carbon. The self-assembling material of an embodiment of the present invention 3 provides LSP and is subsequently coated with a primer 2 and top coat 1 protective and decorative paint layers. In alternate embodiments of the present invention, monolithic structures, i.e. those based on just fiber prepregs, are also commonly encountered. Prepregs and related fiber reinforce resins can consist in number of different forms such as woven-fibers embedded in resin, unidirectional fibers within a resin (e.g. in the form of a large ply or a tape), or pultruded fibers that are impregnated with a resin. Fiber reinforcement can consist of many different types of fibers and many fiber configurations such as fibers made of glass, carbon, boron, aramid, silicon carbide, etc. and fiber configurations such as unidirectional tows or woven fabrics. Furthermore, as previously mentioned the self-assembling material of the present invention may be used with resin component traditionally used to form fiber prepregs, pultruded tows and the like. In another embodiment, the substrate may be comprised of fiber reinforce plastic.

In another embodiment of the present invention, because of the organic component's ability to react and form covalent bonds, it can be easily co-cured with or cured on reactive or non-reactive (e.g. thermoplastic or a previously reacted thermoset) substrates, respectively. In addition, proper selection of resin chemistry potential affords the replacement of one or more layers typically found on the outer part of aircraft, such as primer and topcoat layers used to paint the aircraft (i.e. layers 1 and 2 in Figure 1). Furthermore, with appropriate selection of filler, the present invention is capable of providing lighting strike and corrosion performance without the need of an isolation ply.

Furthermore, because of its highly conductive, isotropic nature it is capable of being used a multifunctional material for the purpose of protection against lighting strike and, but not limited to, shielding against electromagnetic fields caused by indirect effects from a lightning strike or from man-made sources such as electronic and communications. Moreover, the material may also serve to eliminating the buildup of static charge through electrostatic dissipation, or as a heat conduit for melting ice as part of a deicing system. Moreover, the multifunctional ability of the composition overcomes the issues of having to combine metallic structures, e.g. EMFs, with adhesive films prior to its integration into the composite structure.

In another embodiment of the present invention, the cured self-assembled material provides a clear path to ground along the skin of a composite aircraft or other substrate. This path to ground allows manufacturers to reduce the amount of grounding wires for electrical devices by employing the conductive material to complete a circuit.

As previously mentioned, the fabrication of the LSP - fiber prepreg substrate may be accomplished via co-curing the materials together during typical composite processing techniques such as autoclaving curing, out of autoclave curing, or compression molding. Alternatively, the self-assembling adhesive could be cured after the underlying composite substrate has been cured. Moreover, the self-assembling adhesive could be cured to thermoplastic substrate. In a further embodiment, increased pressure levels which are commonly encountered in the composite processing and curing, may further aid in the sintering of the filler particles that occurs following the self-assembly of the composition. Examples of composite applications comprise: wing and tail skins, control surfaces, aerofoils, radomes, helicopter blades, wind turbine blades, stringers, spars, and ribs.

In another embodiment of the present invention, the self-assembling material may be used as a LSP adhesive to bond and/or seal a joint, bolt, fastener, rivet, and the like. The material may provide both mechanical integrity and electrical continuity across joining sections to prevent arcing within or around the joint. In a further embodiment of the present invention, the material serves to ground the composite to a substrate, such as an air frame.

As previously mentioned, EMFs are difficulty to repair when damaged. The meshes and the underlying damaged structure must be carefully sanded and cut out and replaced with new material. The difficulty in repair arises in splicing together new EMF with the existing one. It is essential that the new EMF aligns perfectly. If not, gaps arise which limit the flow electricity in future lighting strike events; this can ultimately compromise the safety of the aircraft. Moreover, the EMF can be easily deformed with simple handling. The EMF is also known to cause surface defects in the painting process which requires rework. It for these reasons that much care and time must be taken to ensure adequate repairs using state of art EMF materials.

In a further embodiment of the present invention, the self-assembling material of the present invention is employed for repairing damaged lightning strike surfaces. This repair method overcomes the difficulties of repair associated with metal foils and other such prior art systems. Due to the unique self-assembling conductive structure of the materials of the present invention, the metal-to-metal interfaces do not require alignment as the self-assembling material will form interconnections in-situ when the material is applied to a repair site. The particular means for employing the compositions of the preset invention in a repair procedure include spraying or painting the uncured material onto the section to be repaired, or pre-forming a B-staged or C-staged sheet, then applying the sheet to the damaged area.

In one embodiment of the present invention, a repair process includes the steps of, sanding the panel to remove paint and expose the damaged area including the original conductive material (metal foil, self-assembled conductive pathways, etc.), then cutting around the perimeter of the damaged area using a cut that penetrates through the honeycomb, peeling away the carbon plies and honeycomb, and sanding the top three layers of carbon ply leaving a stepwise structure. Then the bottom of the hole is sanded smooth with a high speed pneumatic angle grinder, and the repair area dusted with oil-free compressed air. Then an adhesive film is applied to the sides and bottom of the hole in the honeycomb, a pre-fabricated honeycomb plug is applied to the repair, and additional adhesive film is placed over the honeycomb and the step scarfed area, before applying 3 plies of carbon fiber prepreg matched to the step sizes of the repair, starting with the smallest. The self-assembling LSP material of an embodiment of the present invention is placed onto the repair area such that it overlapped the existing LSP for electrical conductivity, and the panels are placed on a release coated tool face and a vacuum bag was constructed around them, and the assembly is debulked for 20 minutes, and then cured in an autoclave at 344.74kPa (50psi), 2 hour isothermal at 177C, before lightly scuffing the panels with 240 grit sandpaper and cleaning with oil-free compressed air, and painting the panels with a primer and topcoat as desired.

In an additional embodiment of the present invention, the self-assembling LSP material may be used to repair prior art lightning strike protection systems such as conductive expanded metal foil, metal mesh, carbon-metal fiber co-weaves, metalized carbon, metalized fiberglass or filled conductive polymer. The unique self-assembling material of embodiments of the present invention, allow for easy application to a damaged area and "automatic" alignment with the existing conductive pathways to form a continuous conductive path between he prior art system and the self-assembled repair material of the present invention.

In a further embodiment of the present invention, the self-assembling conductive material enables the use of automated manufacturing equipment for applying LSP to composite structures. Examples include, but are not restricted to, applying the self-assembling material in spray form using automated spray equipment such that the sprayed material is applied to uncured fiber reinforced polymer skin on a male mold structure, or to the surface female mold structure which has been pretreated with a release agent. Furthermore, the self-assembling material could be applied in combination with multiple unidirectional filaments (e.g. fiber or tape) using automated fiber or tape placement machines. The ability to form continuous electrically conductive pathways following the curing of adjacent filaments overcomes the aforementioned issues manufacturing and weight associated with state of art materials.

In a further embodiment of the present invention, the self-assembling conductive material allows for non-destructive inspection (NDI) of the material as applied to a surface. NDI techniques are critical in applications such as the fabrication of composite aerospace structures. NDI methods allow significant savings in fabrication time and cost while also allowing mission-critical structures to be made to the utmost quality standards. The materials of the present invention, enable simple quantitative non-destructive inspection techniques for LSP skins over the lifetime of the skin. The cured LSP layer can be quickly inspected by contacting the surface with a standard electrical resistance probe, such as a 4-point probe. The electrical resistance values can then be correlated with performance regarding the level of lightning strike protection and electromagnetic interference (EMI) shielding. The surface resistance is dependent on the volume conductivity of the material as well as the thickness of the coating.

In one embodiment of the present invention, the cured self-assembled coating is electrically conductive in all three dimensions (width, length and thickness). Thus, electrical resistance measurements can be easily taken on the surface of the coating using a standard device such as a 4-point probe connected to an ohmmeter.

### EXAMPLES

The self-assembling lightning strike protectant composition described in the Examples comprise diglycidyl ether of bisphenol F (DGEBF) resin (or a blend of DGEBF with diglycidyl ether of dipropylene glycol), an amine adduct curative based on the reaction with diethylene triamine and pthalic anyhydride, and silver flake coated with stearic acid (surface area of about 0.8 m²/g, and weight loss in air at 538°C of about 0.3%), and optionally a solvent based on a blend of toluene, methyl ethyl ketone, ethyl acetate, and ligroine (35%, 32,%, 22%, 11% by weight, respectively).

These coatings were converted into a number of different application forms, applied and co-cured with a composite laminate structure (test panel), and tested for lightning strike performance. These LSP materials and methods ultimately provide protection against lightning strikes because of their ability to form highly conductive, continuous electrical pathways in all orthogonal directions. In other words, the materials ingredients self-assemble to form a conductive three-dimensional mesh during the curing the material. Furthermore, these materials enable direct and indirect protection at substantially reduced weight relative state of the art expanded metal foil protection systems. Ultimately, the self-assembling LSP materials of the embodiments of the present invention have the potential to overcome many of the issues encountered with state of art materials such as handling, processing, automation, repair issues, among other issues mentioned earlier. The following are a list of supportive Examples preceded by description of materials, panel construction, and lightning strike test conditions.

Figure 1 shows the cross section of the laminate test panels used for testing different lightning strike systems described herein. The laminate configuration was chosen to represent the type of construction that may be found on fixed and/or rotary wing aircraft. The construction is also akin to composite laminates used in composite blades for wind turbines and helicopter blades, both of which are susceptible to lightning strikes. Table 1 lists the materials used to construct the panels. Details of the LSP systems used are described hereafter.

**Table 1. List of materials used to prepare lightning test panels.**

| Material | Layer No. in Figure 1 | Description |
|---|---|---|
| Urethane Topcoat | 1 | PPG CA80000 C5 Aerospace-grade urethane paint |
| Epoxy Primer | 2 | PPG 515-349Aerospace-grade sandable epoxy primer |
| LSP System | 3 | See Specific Examples |
| Carbon prepreg | 4-6, 10-12 | Heatcon® (HCS2402-050) 3k-70-Plain Weave Carbon Fiber Epoxy |
| Adhesive Film | 7,9 | Heatcon® Epoxy Adhesive Film (HCS2404-050) |
| Honeycomb | 8 | Nomex honeycomb, 3/8" thick, 1/8" cell |

Composite panels, 60.9 cm x 60.9 cm x 1.27 cm (24 in x 24 in x 1/2 in), were constructed per the general procedure described hereafter. Materials were first cut into 60.9 cm x 121.8 cm (24 in x 48 in) shapes. Layers 3-6 and 10-12 (see Figure 1) were laid up separately by hand, vacuum bagged, and debulked under vacuum to remove entrapped air and ensure intimate contact between adjacent plies. The two laminates were then removed from the bag and combined with the honeycomb core material (layer 8). The resulting laminate was contained in a 60.96 cm x 121.92 cm (24 in x 48 in) support frames that were adhered to an aluminum table top (tool surface). The aluminum table top was treated with a Frekote® mold release coating prior to laying up the materials. The lighting strike protection (LSP) layer (layer 3) was oriented face down against the tool surface. The multilayer laminate was covered with release film, bleeder cloth, and vacuum bagging film. The bagging film was adhered to the tool surface with mastic tape. Vacuum was applied to the bag for ~ 20 minutes prior to autoclave curing. The entire laminate-tool assembly was placed in an autoclave, equipped with vacuum connections, and cured using the following conditions:
Ramp: 1.25°C / minute (2°F / minute), i.e. ~ 2hrs to temp
Soak: 179 +/- 6 °C (355 +/- 10 °F), 2 hours
Pressure: 344.74 kPa (3.40 atm (50 psi))
Cool Down: Max 3.75 °C (6 °F / min) to 27 °C (80 °F.) over the course of -45-60 min Air cool overnight under static vacuum.

The cured panels were removed from the vacuum bag/tool assembly and cut into 60.9 cm x 60.9 cm (24 in x 24 in panels). Each panel was painted with an epoxy primer and urethane topcoat paint. Prior to painting, the surface of each panel was lightly sanded with 240 grit sand paper. Masking tape was applied to the outer 2.54 cm (1 in) edge of the panel. The epoxy primer (layer 2) was then applied at a target wet film and dry thicknesses of 38 µm (0.0015 in) and 19 µm (0.00075 in), respectively. The primer was allowed to dry for a minimum of 2 hours before application of the urethane topcoat (layer 1). The urethane topcoat was applied in two applications. The first application was targeted at a wet film thickness of 50 µm (0.002 in). The second application was targeted at a wet film thickness of 64 µm (0.0025 in). Approximately 7-13 minutes was allotted for drying time between the first and second applications. The panel was allowed to dry for a minimum for 2 hours before handling. Further details of the how the various LSP materials were prepared and incorporated to the laminates are described in the below Examples.

Zone 1A and Zone 2A lighting strike testing was conducted according to SAE ARP5412. Panels were positioned - 2.54 cm (1 inch) below the emitting electrode. Grounding straps were positioned and fixed with C-clamps along the unpainted 2.54cm (1 inch) perimeter of the panel. Visual inspection was done on all panels follow testing. Extent of damage was quantified in terms of extent of lightning penetration and surface area damage.

### EXAMPLE 1

Table 2 compares the Zone 1A strike results for various LSP systems (represented pictorially by Layer 3 in Figure 1). Specific details of the various panels and corresponding LSP systems are as follows: Panel A contained no lightning strike protection system, i.e. Layer 3 (see Figure 1) was absent during panel construction. Panels B and C (State of Art) were compromised of aluminum and copper Expanded Metal Foils (EMF) that were supplied pre-embedded in a surfacing adhesive film (SG4528-016AL-104V and SG4528-04CU-103V, respectively, from APCM-AME, Plainfield, Connecticut) which was further combined with a glass-fiber isolation ply (FGF108-29M-990, Toray Composites America, Inc). The isolation ply was situated between the EMF-adhesive film and topmost carbon fiber layer (Layer 4 in Figure 1). Ref1 and Ref2 provide additional EMF data previously reported by Welch et al of Spirit AeroSystems (SAMPE Journal, Vol. 44, No. 4, July/August 2008, pp. 6-17). The panels described in this report are very similar in construction to those constructed for the Examples herein (see Figure 1). The LSP system for Ref1 has the same configuration as Panel A, i.e. an aluminum EMF embedded in a surfacing film (Surface Master 905) that was overlaid on a glass fiber isolation ply (Style 1581, S2 glass). The LSP for Ref2 consisted of copper EMF embedded in a surfacing film (Surface Master 905). Note Ref2 does not contain a glass isolation ply, unlike Panels B, C, and Ref1.

Panels D-F were based on the self-assembling materials of an embodiment of the present invention. The LSP materials for Panels D and E were formed into adhesive films based on the aforementioned resin, curative, and filler. Specifically, both films were prepared via the following manner: Adhesive pastes comprising 17.8 wt% diglycidyl ether of bisphenol F, 6.8 wt% amine adduct curative, and 75.4 wt% silver flake (25% by volume) using a Hauschild, dual action centrifugal mixer.

These pastes were then drawn into 66.0 cm x 66.0 cm (26 in x 26 in) films nominally 50 µm in thickness. Film drawing was done using a 71.1 cm x 68.6 cm (28in x 27in) mirror surface that was tightly covered with a fluoropolymer release film (Airtech WL5200 0.002in). 50 µm (0.002 in) thick, brass foil strips were placed on two outside edges of the mirror to control the film thickness. Nominally, 200 grams of the self-assembling adhesive were applied to the release film in two beads running the width of the release film surface. A custom-made aluminum draw down bar, 68.6 cm (27 in) wide x 3.8 cm thickness (1.5in) was slowly moved by hand, under pressure, along the surface of the release film toward the opposite end. As the bar passed over the beads of conductive paste, the paste was drawn down into a uniform film. The film thickness was governed by the thickness of the brass foil strips. Multiple casts using the draw-down bar were required until the desired film thickness and uniformity was reached.

Once the adhesive film was cast, a top release film was applied for protection. The entire 3 layer laminate (release film, conductive film and top release film) was passed through a slip roll to improve any film irregularities. The laminate film was then placed on a sheet metal substrate and partially cured (B-Staged) in a preheated oven at 85°C for 13 minutes. After B-staging, the film was cohesive, yet still flexible and the top release film could be removed without causing damage. The B-staged films were stored at -20 °C or below until needed for layup and curing of test panels.

Panel F is a spray-version of a LSP self-assembling adhesive according to an embodiment of the present invention. Conductive paste was prepared in the same manner as above using the following ingredients: 6.5 wt% diglycidyl ether of bisphenol F, 6.5 wt% diglycidyl ether of dipropylene glycol, 4.8 wt% amine adduct curative, and 82.24 wt% silver flake (33% by volume). The pastes were mixed by hand with a solvent blend comprising 36% toluene, 32% methyl ethyl ketone, 22% ethyl acetate, and 10% ligroine, by weight, at a ratio of approximately 1 part solvent to 2 parts paste by weight. The mixture was spray coated onto uncured laminate panels using a HVLP spray gun. The resulting material was loaded into the HVLP spray gun (∼103.42 to 206.84 kPa (-15-30 psi air, 1.4 mm tip)) and applied to uncured fiber glass isolation ply ((FGF108-29M-990, Toray Composites America, Inc) supported by the three uncured carbon plies underneath (Layers 4-6) at distance of 20-30 cm (8-12in) from the surface. The coating thickness was approximately 107 µm (0.0042 in). The substrates were allowed to dry at ambient conditions for a minimum of 10 minutes and then cured under the aforementioned conditions.

Before discussing the results, it's important to comment on the basic criteria for lightning strike protection. The basic criterion for LSP is prevention of "catastrophic effects", i.e. effects that compromise the safety of the aircraft which prevent it from being landed safely. From a structural standpoint it is desirable to preserve the underlying composite substrate following a strike. Ideally, minimal to no breakage of the fibers within the composite laminate substrate is preferred. In addition, it is desirable, although not critical, to have minimal cosmetic damage to the painted surface. Minimizing the burn or scorch area will minimize the amount of materials and time needed for subsequent repair damaged surface. With this in mind, the panels in this and subsequent Examples were inspected for structural damage, i.e. damage to carbon plies, and cosmetic damage, extent of burn or scorch area.

In addition, the action integral measured during the strike test is also reported. Per SAE ARP5412, the action integral is related to the amount of energy absorbed and is a critical factor in the extent of damage. The action integral for Zone 1 A tests should be 2x10⁶A²s (+/- 20%). Considerable deviations below this value under equal test conditions indicates significant absorption of energy which is often reflected in physical damage to the test specimen, e.g. burn through, punctures, etc.

The results in Table 2 show varying degree of protection or damage to Zone 1A strikes depending upon the choice of LSP system. Panel A, having no lightning strike protection, exhibited catastrophic failure. The lightning penetrated all six carbon plies of the panel; thereby resulting in a large hole and extensive burn damage. Moreover, the action integral measure fell well below the accepted level which is further indication of significant absorption of strike energy and the material's inability to adequately ground the current.

All of the state of art EMF systems (Panel B, Panel C, Ref1, and Ref2) prevented penetration of the lightning into the underlying carbon structure with varying degrees of surface damage or cosmetic damage. Panels B and C exhibited comparable amount of surface/cosmetic damage which is to be expected given their very similar construction. Furthermore the level of surface damage considerable less than the observed for the copper systems, Panels C and Ref2. This result is largely due to the less volume of metal within the LSP system owing to the more dense copper. As expected, the heavier copper system (Panel C) outperforms Ref2 because of the larger amount of copper in the LSP system of Panel C. Understandably, all action integrals were in specification owing to adequate LSP.

Similar to the EMF prior art systems, the panels based on the materials and methods of the present invention including a self-assembling material containing conductive pathways prevented penetration of the lightning into the underlying structure and in turn acceptable action integrals. This was true for both film and spray versions of the material. Panel D, a film version of the self-assembled material accompanied with an isolation-ply, exhibited performance and weight levels close to that of the copper/surfacing film used in Panel Ref2. Removal of the isolation ply in the heterogeneous film (Panel E) provides protection at substantially reduced weight relative to the state of art EMF systems. Specifically, Panel E prevents damage to the carbon substrate at ∼22% less weight than the lightest EMF benchmarks (Panels B and Ref2). Panel F demonstrates that spraying a conductive coating directly onto the carbon prepreg followed by co-curing is capable of providing direct protection against Zone 1A simulated lightning, i.e. no carbon plies were penetrated.

**Table 2. Summary of Results for Zone 1A Lightning Strike Tests**

| Panel Name | LSP System (Areal Weights, g/m²) | Total Areal Weight of LSP System, g/m² | Number of Carbon Plies Penetrated | Damage to Surface^{(b)}, cm | Action Integral, x 10⁶ A²·s |
|---|---|---|---|---|---|
| No LSP Protection | | | | | |
| A | None | 0 | 6 | 24 | 1.42 |

| State of Art Expanded Metal Mesh Systems | | | | | |
|---|---|---|---|---|---|
| B | Al (78) + Isoply (82)+ Surfacing Film (171) | 331 | 0 | 23 | 2.04 |
| C | Cu (195) + Isoply (82)+ Surfacing Film (181) | 458 | 0 | 28 | 2.08 |
| Ref1^{(a)} | Al (78) + Isoply (82)+ Surfacing Film (171) | 331 | 0 | 14 | NA |
| Ref2^{(a)} | Cu (78) + Surfacing Film (171) | 313 | 0 | 29 | NA |

| Self-assembling LSP Materials | | | | | |
|---|---|---|---|---|---|
| D | Hetero Film (261) + Isoply (82) | 343 | 0 | 35 | 1.90 |
| E | Hetero Film (261) | 257 | 0 | 23 | 1.97 |
| F | Hetero Spray (452) + Isoply (82) | 532 | 0 | 19 | 2.08 |

| | | | | | |
|---|---|---|---|---|---|
| (a) Ref1 and Ref2 are based Zone 1A test results for EMF LSP systems previously reported by Welch et al. of Spirit AeroSystems (SAMPE Journal, Vol. 44, No. 4, July/August 2008, pp. 6-17). The panels described in this report are very similar in construction to one those listed rest of Table 1. Further details can be found within the text description of the examples and within the referenced article. (b) The surface damage corresponds to the diameter of circular area that has been damaged cosmetically via charring, burning, or evaporation of paint and/or resin. | | | | | |

### EXAMPLE 2

Table 3 compares the Zone 2A strike results for various LSP systems (represented pictorially by Layer 3 in Figure 1). Panel G (State of Art) was compromised of aluminum EMF (Grade 016, Pacific Coast Composites) that was combined with a film adhesive (HCS2404-050, 242 g/m², Heatcon® Composites) which was further combined with a glass-fiber isolation ply (FGF108-29M-990, Toray Composites America, Inc). The isolation ply was situated between the EMF-adhesive film and topmost carbon fiber layer. Panel H was prepared in the same manner as Panel F except using the following ingredients for conductive paste and solvent blend. Conductive paste: 25.1 wt% diglycidyl ether of bisphenol F, 9.6 wt% amine adduct curative, and 65.3 wt% silver flake (17% by volume). Solvent blend: 50% acetone, 18% toluene, 16% methyl ethyl ketone, 11% ethyl acetate, and 5% ligroine, by weight.

Although both panels in Table 3 prevent catastrophic failure and demonstrate acceptable Action Integrals (i.e., 0.25 +/- 20%), Panel G based on the aluminum EMF exhibited damage to the first ply of carbon fiber. In contrast, no penetration of carbon plies was observed for Panel H based on the self-assembling material of an embodiment of the present invention. Moreover, the areal weight was half of that of the benchmark. This unique performance of the present inventions stems in part from the isotropic nature which allows for very high conductivity in the z-direction in addition x- & y-directions.

**Table 3. Summary of Results for Zone 2A Lightning Strike Tests.**

| Panel Name (Figure No.) | LSP System (Areal Weights g/m²) | Total Areal Weight of LSP System (g/m²) | Number of Carbon Plies Penetrated | Damage to Surface^{(a)}, cm | Action Integral, x 10⁶ A²·s |
|---|---|---|---|---|---|
| State of Art Expanded Metal Mesh Systems | | | | | |
| G | Al (78) + Isoply (82)+ Surfacing Film (242) | 404 | 1 | 6 | 0.28 |

| Heterogeneous LSP Materials | | | | | |
|---|---|---|---|---|---|
| H | Hetero Spray (202) | 202 | 0 | 12.5 | 0.26 |

| | | | | | |
|---|---|---|---|---|---|
| (a) The surface damage corresponds to the diameter of circular area that has been damaged cosmetically via charring, burning, or evaporation of paint and/or resin. | | | | | |

### EXAMPLE 3

As previously mentioned, the self-assembling nature of the materials of the present invention have the ability to form continuous, conductive pathways during the curing of material. This feature is especially unique as it enables one to electrically bridge interfaces (e.g. a splice between two adjacent sections) that are commonly encountered in the original construction of structures and during the repair of existing ones. Furthermore, this method enables one to automate the LSP manufacturing process. State of art materials based on metal foils lack the ability to form continuous interfaces at splice, which often leads to very large electrical resistances across interfaces between separate LSP EMFs. Moreover, automated of these LSP is prohibited owing to splice issues, fragility, and weight issues.

To illustrate the ability of the present invention to electrically bridge interfaces, the same self-assembling LSP material for Panel H was spray coated onto two different 10 cm x 30 cm (3.9 in x11.8 in) single plies of carbon fiber pregreg (3k-70-PW Carbon Fiber Epoxy). The resulting coating was approximately 75 µm (0.003 in) in thickness. The two coated plies were then butt spliced together on a metal tool surface (coating against surface), thus creating a linear defect along the interface of the two samples. Two 20 cm x 30 cm (7.9 in x 11.8 in) carbon fiber plies were applied to the back of the splice plies. The entire structure was then vacuum bagged and cured at 177°C (350 °F) for 3 hours. Electrical resistance measurements were taken using a 2x2 point probe with 7 cm probe spacing within each original coating and across the butt splice joint. The cured coating exhibited comparable electrical conductivity across the initial butt splice defect as measured within each of the original samples. This is attributable to the unique structure of the material which allows enables the self-assembling conductive pathways to form electrical connections with the pre-existing LSP system.

**Table 4. Electrical resistance values for spliced carbon panels based on heterogeneous/self-assembling conductive coatings.**

| Panel Location | Electrical Resistance^{(a)} (mOhms) |
|---|---|
| Within Left Laminate | 91.1 |
| Within Right Laminate | 91.1 |
| Across original butt splice of two laminates | 88.9 |

| | |
|---|---|
| (a) The electrical resistance was measured using a 2x2 four point probe with a probe to probe spacing of 7 cm. | |

### EXAMPLE 4

Composite sandwich panels that were previously struck by Zone 1A simulated lightning were used as test specimens. Two types of panels were used: Panel G based on expanded copper foil (state of art) and the Panel H based on a self-assembling adhesive coating. Both panels were repaired according FAA approved methods using a step-sand approach (DOT/FAA/AR-03/74). Both panels were repaired with a spray solution based on the aforementioned self-assembling spray adhesive described in Example 1. The adhesive-solvent mixture was loaded into the HVLP spray gun (103.42 to 206.84 kPa (15-30 psi air), 1.4 mm tip) and applied to the repaired panels.

Specific details of the entire repair process are as follows: Panels were sanded with a dual orbital sander to remove paint and expose damage. This sanding also exposed the copper EMF in the case of Panel G, which allowed the self-assembling material to make electrical contact with the foil. A circular cut that penetrated through the honeycomb was then made around the perimeter of the damaged area. The carbon plies and honeycomb were peeled away. The bottom of the hole was then sanded smooth with a high speed pneumatic angle grinder. The top three layers were carbon were then sanded away thereby leaving a stepwise structure. The step size was 1.27cm/ply. The repair area was then dusted with oil-free compressed air. Next, adhesive film (see Table 1) was applied to the sides and bottom of the hole in the honeycomb. A honeycomb plug was fabricated and applied to the repair. Adhesive film was placed over the honeycomb and the step scarfed area. Three plies of carbon fiber prepreg (see Table 1) matched to the step sizes were applied to the repair, starting with the smallest. The self-assembling adhesive spray solution was sprayed onto the repair area such that it overlapped the existing LSP for electrical conductivity. The panels were placed on a release coated tool face and a vacuum bag was constructed around them. The assembly was debulked for 20 minutes, and then cured in an autoclave at 344.74 kPa (50psi), 2 hour isothermal at 177°C. Following curing, the panels were lightly scuffed with 240 grit sandpaper and cleaned with oil-free compressed air. They were then primed and painted as previously described.

The repaired panels were struck directly on the repair site with Zone 1A as previously described. Both repairs were able to adequately protect the composite panels without any significant structural damage to the panel. The damage was isolated to the plug area in the form of char and evaporated resin from the edges and top carbon layer of the repair. In both cases the plug remains firmly in place after the strike. The discoloration of the paint around the perimeter of the repair was primarily in the form of soot that was easily removed by cleaning.

### EXAMPLE 5

A self-assembling adhesive paste of the present invention was prepared using the following formulation: 25.3 wt% diglycidyl ether of bisphenol F, 9.7 wt% amine adduct curative, and 65.0 wt% silver flake (about 17% by volume). The components were mixed until uniform in a Hauschild DAC 150 FV mixer.

A solvent blend was then mixed into the paste at a ratio of 1 part solvent blend to 2 parts paste. The solvent blend consisted of 50% acetone, 18% toluene, 16% methyl ethyl ketone, 11% ethyl acetate, and 5% ligroine, by weight.

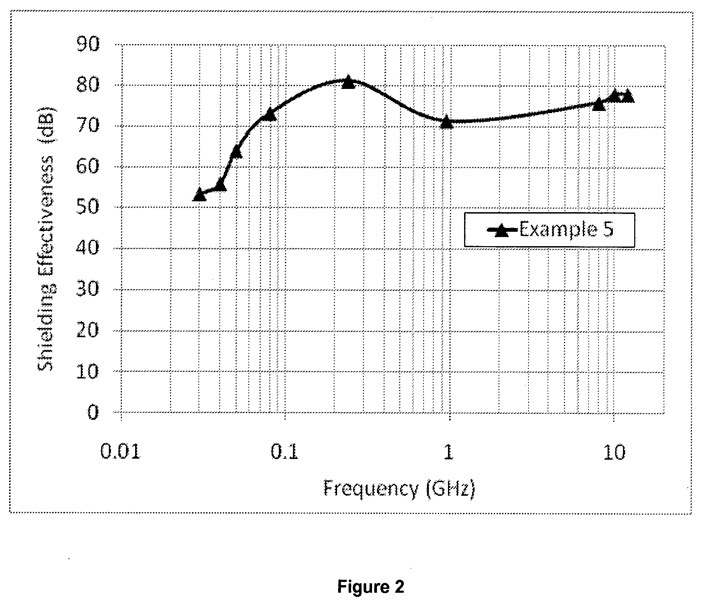

The resulting paint mixture was briefly mixed manually followed by 5 minutes of mixing on a standard paint shaker. The paint mixture was then strained and loaded into a gravity-fed hand held HVLP spray gun with a 1.4 mm tip size and 103.42 to 206.84 kPa (15-30 psi) of air pressure. The paint mixture was then sprayed onto a nonconductive G11 epoxy board substrate. (The non-conductive substrate was chosen due to its transparency to the electromagnetic waves which would allow for measuring the true shielding effectiveness of the conductive coating.) The coated substrate was then cured at 160 °C for 1 hour. The sheet resistance of the cured film averaged 0.036 Ω/square as measured by a 4 point probe. The film thickness was approximately 50 µm (0.002 in). The electromagnetic shielding effectiveness of the coating was measured using a modified MIL-STD-285 procedure in plane wave at frequencies of 30 MHz to 12 GHz. It is important to note that the testing results below 240 MHz are semi-quantitative since the 60.9 cm x 60.9 cm (24 in x 24 in) sample holder (aperture) begins to block EM transmission as well. The results in Figure 2 show that the coating based on the present invention is capable of providing high levels of shielding effectiveness, i.e. 50 dB and higher, over a broad range of frequencies.

### EXAMPLE 6

The self-assembling LSP material according to an embodiment of the present invention was applied onto commercial carbon fiber reinforced polymer (CFRP) plies. The support structure under these surface CFRP plies was a Nomex® honeycomb core and additional CFRP plies on the back side. These flat panels were autoclave co-cured at 179.4 +/- 5.5 °C (355 +/- 10 °F). The result was a fully cured CFRP honeycomb panel cropped to 60.96 cm x 60.96 cm x ~1.27 cm (24" x 24" x ∼0.5") with a LSP coating on one surface.

After curing, these flat panels approximate a composite aircraft skin structure before primer and topcoat painting. Electrical resistance measurements can be easily made on the LSP coating's surface. These measurements can be spot tests using all 4 probe pins located together, or distance tests where each pair of probe pins are spaced a given distance apart. The panels were then painted with aerospace grade primer and topcoats and underwent Zone 1A lightning strike tests per SAE 5412 specifications.

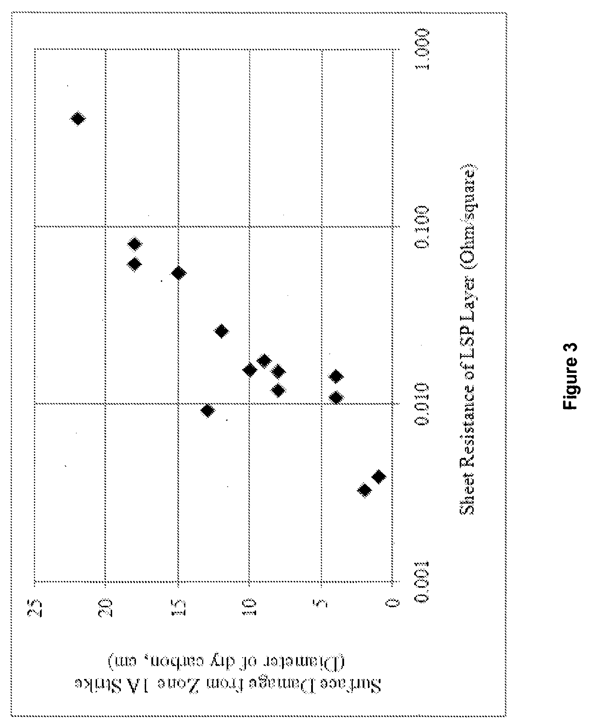

Figure 3 shows how surface resistance can be used to predict LSP performance which is a value method in assess quality during manufacturing and extent of damage after strike or an impact. In Figure 3, the LSP coating's electrical resistance is graphed against the damaged area of the same panel after the Zone 1 A lightning strike. The electrical resistance of the coating was measured with a 4-pt probe spot test. The damaged (or "dry") area of the struck panel was defined as the absence of the paint layers, LSP layer and surface resin from the CFRP plies. All panels in Figure 3 exhibited structural damage to only 0-1 CFRP plies.

## Claims

1. A method for shielding a substrate from lightning strikes, said method comprising:
(i) providing a substrate,
(ii) providing lightning strike protectant composition to the substrate, wherein the lightning strike protectant composition comprises a filled, curable material capable of self-assembling to form conductive pathways during a cure process, wherein the curable material comprises a curable organic compound and a filler, said organic compound comprising a relatively non-polar resin and a polar curing agent and said filler being comprised of particles, said particles being coated with a non-polar coating and comprising a material that is electrically conductive, and said coated filler particles being mixed in said organic compound, and
(iii) curing the composition by means of the application of heat, wherein curing agent reacts with the resin of the curable organic compound forming a polymer having polar moieties thereon, resulting in a repulsive interaction between the non-polar coating on the filler and the polar moieties on the polymer, causing the filler to self-assemble into conductive pathways through the composition.

2. The method of claim 1, wherein the curable organic compound comprises diglycidyl ether of bisphenol F, preferably wherein the curable organic compound further comprises a cure agent, preferably wherein the cure agent comprises a polyamine anhydride adduct based on reaction between phthalic anhydride and diethylenetriamine.

3. The method of claim 1, wherein the conductivity of the cured self-assembled composition is greater than 100 times the conductivity of a cured non-self-assembled composition having an equivalent amount of the conductive filler.

4. The method of claim 1, wherein the filler comprises silver, and optionally, wherein the coating comprises stearic acid.

5. The method of claim 1, further comprising the step of heating the composition to cure the material.

6. The method of claim 1, wherein the filler particles are sintered to form sintered conductive self-assembled pathways.

7. The method of claim 1, wherein the lightning strike protectant composition is incorporated into a laminate structure further comprising a prepreg substrate, preferably wherein the laminate structure further comprises an additional pre-formed conductive matrix, preferably wherein the pre-formed conductive matrix comprises an expanded metal foil.

8. The method of claim 1, wherein the self-assembled material further provides a path to ground for at least one electrical device.

9. The method of claim 1, wherein the composition comprises less than 40 volume percent conductive filler, or wherein the composition comprises less than 15 volume percent conductive filler.

10. The method of claim 1, wherein the step of providing a lightning strike protectant composition to a substrate comprises the following steps:
identifying a damaged section of a lightning strike protection system comprising at least one discontinuous conductive pathway;
depositing the composition onto the damaged section; and,
curing the deposited composition to provide at least one self-assembled conductive pathway completing the at least one discontinuous conductive pathway in the damaged section.

11. The method of claim 10, wherein the damaged lightning strike protection system comprises at least one of a conductive expanded metal foil, metal mesh, carbon-metal fiber co-weaves, metalized carbon, or filled conductive polymer, or
wherein the damaged lightning strike protection system comprises a curable material capable of self-assembling to form conductive pathways during a cure process.

## Patentansprüche

1. Verfahren zum Abschirmen eines Substrats gegenüber Blitzschlägen, wobei das Verfahren umfasst:
(i) Bereitstellen eines Substrats;
(ii) Auftragen einer Blitzschlagschutzzusammensetzung auf das Substrat, wobei die Blitzschlagschutzzusammensetzung ein gefülltes härtbares Material umfasst, das während eines Härtungsvorgangs zur Selbstorganisation unter Bildung von leitfähigen Bahnen befähigt ist, wobei das härtbare Material eine härtbare organische Verbindung und einen Füllstoff umfasst, wobei die organische Verbindung ein relativ unpolares Harz und ein polares Härtungsmittel umfasst und der Füllstoff aus Teilchen besteht, wobei die Teilchen mit einer unpolaren Beschichtung beschichtet sind und ein Material umfassen, das elektrisch leitfähig ist, und die beschichteten Füllstoffteilchen in die organische Verbindung gemischt werden; und
(iii) Härten der Zusammensetzung durch Anwendung von Wärme, wobei das Härtungsmittel mit dem Harz der härtbaren organischen Verbindung reagiert, wobei ein Polymer entsteht, auf dem sich polare Struktureinheiten befinden, was zu einer abstoßenden Wechselwirkung zwischen der unpolaren Beschichtung auf dem Füllstoff und den polaren Struktureinheiten auf dem Polymer führt, was bewirkt, dass sich der Füllstoff selbst zu leitfähigen Bahnen organisiert, die durch die Zusammensetzung verlaufen.

2. Verfahren gemäß Anspruch 1, wobei die härtbare organische Verbindung Diglycidylether von Bisphenol F umfasst, wobei die härtbare organische Verbindung vorzugsweise weiterhin ein Härtungsmittel umfasst, wobei das Härtungsmittel vorzugsweise ein Polyaminanhydrid-Addukt umfasst, das auf der Reaktion zwischen Phthalsäureanhydrid und Diethylentriamin basiert.

3. Verfahren gemäß Anspruch 1, wobei die Leitfähigkeit der gehärteten selbstorganisierten Zusammensetzung größer als das 100-fache der Leitfähigkeit einer gehärteten nichtselbstorganisierten Zusammensetzung, die eine äquivalente Menge des leitfähigen Füllstoffs aufweist, ist.

4. Verfahren gemäß Anspruch 1, wobei der Füllstoff Silber umfasst und wobei die Beschichtung gegebenenfalls Stearinsäure umfasst.

5. Verfahren gemäß Anspruch 1, weiterhin umfassend den Schritt des Erhitzens der Zusammensetzung, um das Material zu härten.

6. Verfahren gemäß Anspruch 1, wobei die Füllstoffteilchen gesintert werden, um gesinterte leitfähige selbstorganisierte Bahnen zu bilden.

7. Verfahren gemäß Anspruch 1, wobei die Blitzschlagschutzzusammensetzung in eine Laminatstruktur eingebaut ist, die weiterhin ein Prepreg-Substrat umfasst, wobei vorzugsweise die Laminatstruktur weiterhin eine zusätzliche vorgebildete leitfähige Matrix umfasst, wobei vorzugsweise die vorgebildete leitfähige Matrix eine expandierte Metallfolie umfasst.

8. Verfahren gemäß Anspruch 1, wobei das selbstorganisierte Material weiterhin eine Erdung für wenigstens ein elektrisches Gerät liefert.

9. Verfahren gemäß Anspruch 1, wobei die Zusammensetzung weniger als 40 Volumenprozent leitfähigen Füllstoff umfasst oder wobei die Zusammensetzung weniger als 15 Volumenprozent leitfähigen Füllstoff umfasst.

10. Verfahren gemäß Anspruch 1, wobei der Schritt des Auftragens einer Blitzschlagschutzzusammensetzung auf ein Substrat die folgenden Schritte umfasst:
Identifizieren eines beschädigten Abschnitts eines Blitzschlagschutzsystems, das wenigstens eine unterbrochene leitfähige Bahn umfasst;
Abscheiden der Zusammensetzung auf dem beschädigten Abschnitt; und
Härten der abgeschiedenen Zusammensetzung, wobei man wenigstens eine selbstorganisierte leitfähige Bahn erhält, die die wenigstens eine unterbrochene leitfähige Bahn in dem beschädigten Abschnitt vervollständigt.

11. Verfahren gemäß Anspruch 10, wobei das beschädigte Blitzschlagschutzsystem wenigstens eines aus einer expandierten Metallfolie, Metallgitter, Kohle-Metallfaser-Mischgewebe, metallisiertem Kohlenstoff oder einem gefüllten leitfähigen Polymer umfasst; oder
wobei das beschädigte Blitzschlagschutzsystem ein härtbares Material umfasst, das während eines Härtungsvorgangs zur Selbstorganisation unter Bildung von leitfähigen Bahnen befähigt ist.

## Revendications

1. Procédé pour protéger un substrat de la foudre, ledit procédé comprenant les étapes consistant à :
(i) partir d'un substrat,
(ii) procurer au substrat une composition protectrice contre la foudre, où la composition protectrice contre la foudre comprend un matériau de remplissage durcissable, capable d'auto-assemblage pour former des chemins conducteurs durant un processus de durcissement, où le matériau durcissable comprend un composé organique durcissable et un matériau de remplissage, ledit composé organique comprenant une résine relativement non polaire et un agent durcisseur polaire et ledit matériau de remplissage étant composé de particules, lesdites particules étant enrobées d'un revêtement non polaire et comprenant un matériau qui est électriquement conducteur, et lesdites particules de remplissage enrobées étant mélangées dans ledit composé organique, et
(iii) durcir la composition par application de chaleur, où l'agent durcisseur réagit avec la résine du composé organique durcissable formant un polymère portant des groupements polaires, entraînant une interaction répulsive entre le revêtement non polaire sur le matériau de remplissage et les groupements polaires sur le polymère, provoquant l'auto-assemblage du matériau de remplissage en chemins conducteurs à travers la composition.

2. Procédé selon la revendication 1, dans lequel le composé organique durcissable comprend de l'éther diglycidylique de bisphénol F, de préférence, dans lequel le composé organique durcissable comprend en outre un agent durcisseur, de préférence, dans lequel l'agent durcisseur comprend un produit d'addition d'anhydride de polyamine basé sur la réaction entre l'anhydride phtalique et la diéthylènetriamine.

3. Procédé selon la revendication 1, dans lequel la conductivité de la composition durcie auto-assemblée est supérieure à 100 fois la conductivité d'une composition durcie non auto-assemblée, ayant une quantité équivalente du matériau de remplissage conducteur.

4. Procédé selon la revendication 1, dans lequel le matériau de remplissage comprend de l'argent, et facultativement, dans lequel le revêtement comprend de l'acide stéarique.

5. Procédé selon la revendication 1, comprenant en outre l'étape consistant à chauffer la composition pour durcir le matériau.

6. Procédé selon la revendication 1, dans lequel les particules de remplissage sont soumises à un frittage pour former des chemins conducteurs auto-assemblés, frittés.

7. Procédé selon la revendication 1, dans lequel la composition protectrice contre la foudre est incorporée dans une structure stratifiée comprenant en outre un substrat préimprégné, de préférence, dans lequel la structure stratifiée comprend en outre une matrice conductrice préformée supplémentaire, de préférence, dans lequel la matrice conductrice préformée comprend une feuille de métal déployé.

8. Procédé selon la revendication 1, dans lequel le matériau auto-assemblé procure en outre un raccordement à la terre à au moins un dispositif électrique.

9. Procédé selon la revendication 1, dans lequel la composition comprend moins de 40 pour cent en volume de matériau de remplissage conducteur, ou dans lequel la composition comprend moins de 15 pour cent en volume de matériau de remplissage conducteur.

10. Procédé selon la revendication 1, dans lequel l'étape qui consiste à procurer une composition protectrice contre la foudre à un substrat comprend les étapes suivantes :
identifier une section endommagée d'un système de protection contre la foudre, comprenant au moins un chemin conducteur discontinu ;
déposer la composition sur la section endommagée ; et
durcir la composition déposée pour procurer au moins un chemin conducteur auto-assemblé complétant ledit au moins un chemin conducteur discontinu dans la section endommagée.

11. Procédé selon la revendication 10, dans lequel le système de protection contre la foudre endommagé comprend au moins l'un parmi une feuille de métal déployé conductrice, un treillis métallique, des co-tissages de fibre de métal-carbone, du carbone métallisé ou un polymère conducteur de remplissage, ou
dans lequel le système de protection contre la foudre endommagé comprend un matériau durcissable capable d'auto-assemblage pour former des chemins conducteurs durant un processus de durcissement.
